# EUROPEAN PATENT APPLICATION

(11) **EP 3 330 986 A1**
(43) Date of publication of application: **06.06.2018**
(21) Application number: 16306619.4
(22) Date of filing: 05.12.2016
(51) Int. Cl.: H01G 7/02, H02N 1/08

(54) **COMPRESSIBLE FIBROUS ELECTRET STRUCTURE AND ELECTROSTATIC TRANSDUCER FOR KINETIC ENERGY HARVESTING**

(71) Applicant: Chambre de Commerce et d'Industrie de Région Paris Ile de France (ESIEE Paris), 93160 Noisy Le Grand (FR); Université de Marne La Vallee, 77420 Champ Sur Marne (FR)
(72) Inventor: BASSET, Philippe, 94120 FONTENAY SOUS BOIS (FR); LU, Yingxian, 77600 BUSSY SAINT GEORGES (FR); LEPRINCE-WANG, Yamin, 77164 FERRIERES-EN-BRIE (FR)
(74) Representative: Regimbeau

(57) **Abstract**

The present invention relates to a compressible porous fibrous electret film, for use as an electrical film in an electrostatic transducer. Said compressible porous fibrous electret film comprises:
- a layer of tangled micro/nanofibers ,
- said layer of tangled micro/nanofibers being coated with a dielectric conformal coating ,
- said conformal coating conforming the shape of the tangled micro/nanofibers, said coating being adapted to store electrical charges and to be permanently charged with a quantity of electrical charges, whereby the dielectric conformal coating increases the quantity of electrical charges of the electret film by increasing a storage's surface of the electrical charges and the coated tangled micro/nanofibers define pores within the film.

Upon applying a mechanical force (such as by shearing, compressing, and/or stretching) on the electrostatic transducer, electricity is generated. The electrostatic transducer of the invention is thus useful for harvesting kinetic energy or mechanical sensing.

## Description

### TECHNICAL FIELD

The present invention relates to a compressible porous fibrous electret film, for use as an electrical film in an electrostatic transducer, preferably for harvesting kinetic energy or mechanical sensing.

### BACKGROUND ART

An electrostatic transducer is a variable capacitance. It may be used in particular for kinetic energy harvesting or mechanical sensing. In an electrostatic energy harvester, the converted power is optimized by combining (i) a high initial energy stored in the capacitance before the energy conversion, and (ii) a high capacitance variation during energy conversion.

Previously reported works on flexible kinetic energy harvesters are mostly focused on either piezoelectric harvesters [1-3] or triboelectric nanogenerator [4]. Few others use thick materials as electret [5]. Both types can provide repetitive narrow peaks with pressing or bending external forces.

However, there is still a need for efficient electrostatic transducers, which can advantageously be used on soft substrates, such as textiles, in particular shoes or clothes.

### SUMMARY OF THE INVENTION

The Inventors thus provide an electrostatic transducer with a both (i) a high initial energy, and (ii) a high capacitance variation during energy conversion. To this end, the Inventors herein propose using as the dielectric material of the electrostatic transducer a compressible and porous electret film, comprising a compressible and porous fibrous matrix layer coated with a permanently (or quasi permanently) charged dielectric coating.

Thanks to its compressibility, the electret film of the invention is able to exhibit highly efficient capacitance variations when subjected to a mechanical force (such as shearing, squeezing, and/or stretching), thereby inducing electricity in an electrode.

On the other hand, the porosity of the electret film significantly increases the total charge, as compared with the electret of the prior art. This results from the fibrous structure of the matrix layer, and of the conformal nature of the dielectric coating, which retains the porous structure of the matrix layer, thus creating a significantly increased total surface area available for charging, which typically occurs essentially in the coating layer.

In a first aspect, the present invention thus relates to a compressible porous electret film comprising:
- a layer of tangled micro/nanofibers,
- said layer of tangled micro/nanofibers being coated with a dielectric coating adapted to store electrical charges, said dielectric coating being permanently (or quasi permanently) charged.

As used herein, the term "matrix layer" refers to the layer of tangled micro/nanofibers of the electret film.

In the electret film, the matrix layer thus comprises (or consists (essentially) of) tangled micro/nanofibers, and is porous with open pores (in its whole volume).

In addition, the dielectric coating is conformal. As used herein, a "conformal" coating is understood as a coating which retains (conforms to) the geometry and/or shape of the matrix layer. In other words, the electret film, comprising the coated matrix layer, has a fibrous structure similar to that of the matrix layer. In contrast, a "non-conformal" coating may fill the pores of the matrix layer thus rendering the film non porous. This is not the case in the present invention. A "conformal" coating is also preferably homogeneous.

The electret film is thus porous with an open porosity. As a result, the total surface area available for charging (in particular the total surface area of the dielectric coating able to store electrical charges) is larger than in the electrets of the prior art (which have for instance a planar charged surface), thus increasing the total charge of the electret film of the present invention.

More specifically, the present invention relates to a compressible porous fibrous electret film, comprising:
- a layer of coated tangled micro/nanofibers, which comprises : tangled micro/nanofibers coated with a dielectric conformal coating,
- said conformal coating conforming the shape of the tangled micro/nanofibers, said conformal coating being adapted to store electrical charges, and being permanently charged with a quantity of electrical charges,
- the conformal coating increasing the quantity of electrical charges of the electret film by increasing a storage's surface of the electrical charges, and the coated tangled micro/nanofibers defining pores within the electret film.

In another aspect, the present invention relates to a process for preparing the electret film of the invention, comprising depositing a dielectric coating on a layer of tangled micro/nanofibers 11, thus leading to a non-charged electret film 12. When a charged electret is sought for, the process further comprises a step of charging the non-charged electret film by ionizing the air in the vicinity of the dielectric coating and/or within the non-charged electret film.

In another aspect, the present invention relates to an electrostatic transducer comprising:
1) at least one compressible porous fibrous electret film of the invention, and
2) at least two electrodes A, B fitted each on an individual support, with at least one electrode being displaceable relative to the other electrode, thereby modifying the capacitance of the electrostatic kinetic energy harvester transducer,
   - the electret film being arranged between the two electrodes A, B,
   - the two electrodes A, B being arranged to be displaced between:
      a) a released position and a strained position when a mechanical force is applied to at least one of the electrodes, the electret film being - in the strained position -compressed, stretched or sheared,
      b) the strained position and the released position, when the mechanical force is released,
whereby the position of the electret film relative to the two electrodes A, B and/or the thickness of the electret film is modified during the displacement.

In the electrostatic transducer, the compressible porous fibrous electret film is permanently charged with charges of a first sign load.

The two electrodes A, B may be displaced axially (compressing) or laterally (stretching and/or shearing).

Upon applying the mechanical force, at least one electrode comes into physical contact with the electret film, if this is not the case in the released position.

The modification of the position of the electret film occurring when the two electrodes A, B are moving from the strained position to the released position creates a dissymmetry of the charge distribution, thus creating a capacitance variation, which in turn creates electrical power.

When the electrostatic kinetic energy harvester transducer of the invention is operated, its electrodes are charged by way of electrostatic induction, thus having a charge opposite the one of the dielectric layer of the electret.

The present invention relates to an electrostatic transducer (in particular an electrostatic kinetic energy harvester transducer) comprising:
1) at least one compressible porous fibrous electret film of the invention, permanently charged with electrical charges of a first sign load,
2) at least two electrodes A, B fitted each on an individual support, said electrodes having electrical charges of a second sign load opposite to the first sign load electrostatically induced by the charges of the electret film,
   - at least one electrode being displaceable relative to the other electrode, thereby modifying the capacitance for collecting electrical power,
   - the electret film being arranged between the two electrodes A, B,
   - the two electrodes A, B being arranged to be displaced between:
      a) a released position and a strained position when a mechanical force is applied to at least one of the electrodes, the electret film being - in the strained position - compressed, stretched or sheared,
      b) the strained position and the released position, when the mechanical force is released,
the position of the electret film relative to the two electrodes A, B and the thickness of the electret film is modified during the displacement,
which creates a dissymmetry of the charge distribution between the charges of the two electrodes A, B when the two electrodes are moving from the strained position to the released position, for collecting electrical power.

In another aspect, the present invention further relates to the use of the electrostatic transducer of the invention, in particular as mechanical sensor or as kinetic energy harvester, in particular included in a textile (such as a textile for a shoe or for clothes).

The present invention also relates to a method of providing electricity, comprising applying a mechanical force (such as by shearing, compressing, and/or stretching) on the electrostatic transducer of the invention.

The present invention thus further relates to a mechanical sensor or a kinetic energy harvester comprising the electrostatic transducer of the invention. Preferably, the mechanical sensor or kinetic energy harvester is flexible, so that it may be used as wearable electronics. In particular, it may be included in soft substrates such as textiles, for instance in a shoe or in clothes.

### DEFINITIONS

A "dielectric material" (or "dielectric" for short) is an electrical insulator that can be polarized by an applied electric field. When a dielectric is placed in an electric field, electric charges do not flow through the material (as they do in a conductor), but only slightly shift from their average equilibrium positions, thus causing dielectric polarization. Because of dielectric polarization, positive charges are displaced toward the field and negative charges shift in the opposite direction. This creates an internal electric field that reduces the overall field within the dielectric itself.

As used herein, an "electret" is a dielectric material that has a quasi-permanent electric charge or dipole polarisation. An electret generates internal and external electric fields (it may thus be regarded as the electrostatic equivalent of a permanent magnet).

Piezoelectricity relates to electricity resulting from pressure-initiated mechanical deformation. As used herein, a "piezoelectric" material is understood as a material able to convert mechanical energy into electricity and vice versa.

As used herein, a "piezo-electret" is understood as a material exhibiting piezoelectric properties after electric charging, enabling the piezoelectret to permanently trap electric dipoles within itself. Piezoelectrets are usually thin films of porous material, for instance consisting of a cellular polymer structure filled with air, which are elastically soft allowing large deformations of the electrically charged material, generally within the voids of the material.

As used herein, "ferro-electret" and "piezo-electret" have the same meaning and refer to the same type of material.

As used herein, a "quasi permanently" charged material is a material comprising an electrical charge or electrical dipoles, that are stable over a period of at least 1 month, preferably of at least 1 year.

As used herein, the term "flexible" is understood as referring to a material which may adopt a planar as well as a non-planar form.

Both a "flexible" and a "compressible" material are deformable, but as used herein, the term "compressible" refers to a material which may be compressed, stretched or sheared (in other words squeezed) and yet is able to actively recover at least partially its initial form.

As used herein, a "micro/nanofiber" is understood as a fibre with a diameter of between about 100 nm and about 100 µm.

As used herein, a "microfiber" is understood as a fibre with a diameter of between about 1 µm and 100 µm, preferably between 2 µm and 80 µm, for instance between 10 µm and 50 µm.

As used herein, a "nanofiber" is understood as a fibre with a diameter of between about 50 nm and 1 µm, preferably between 100 nm and 850 nm, more preferably between 100 nm and 500 nm, for instance between 100 nm and 250 nm.

As used herein, "tangled fibers" are understood as fibers forming an ordered or disordered mass of fibers, and may in particular refer to a woven as well as a non-woven fiber mass. Preferably, in the present invention, "tangled fibers" refer to a non-woven fiber mass.

In the present invention, there are spaces between the tangled fibers (i.e. voids without matter), but the fibers are also into physical contact, thus creating pores within the tangled fibers.

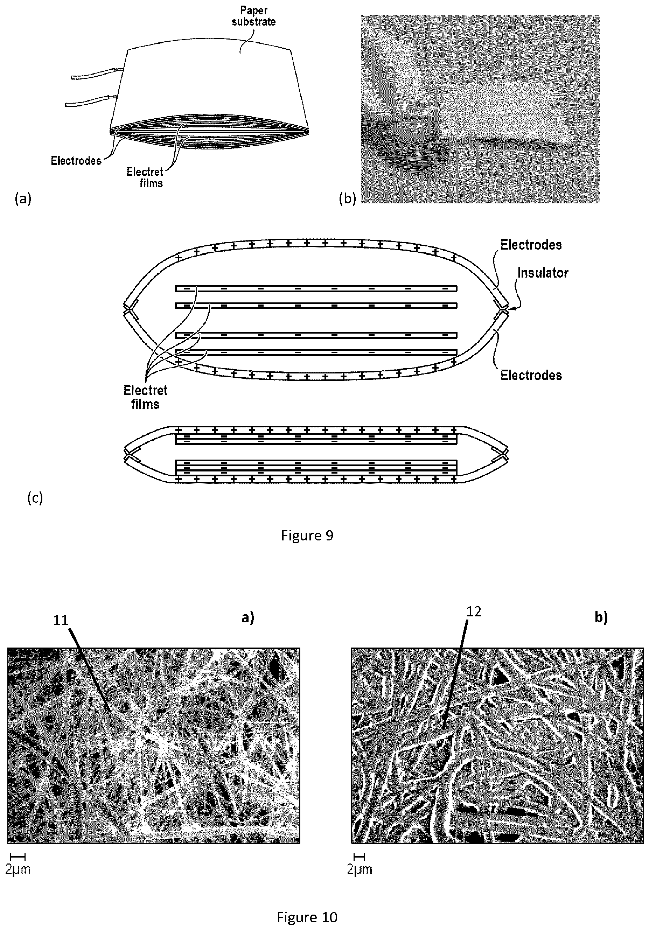

The pores result from the entanglement of the micro/nanofibers which exists between the tangled micro/nanofibers. This is the case both with the micro/nanofibers before and after they are coated. The entanglement of the tangled micro/nanofibers is different after the coating (several micro/nanofibers can be coated together with the dielectric conformal coating and/or can have changed of position in the tangled coating structure). This is in particular represented in figure 10. As shown, the structure of the entanglement with important spaces or voids (or pores) without matter is maintained with the tangled coating structure of the nano/micro fibers. The elongated shape of the micro/nano fibers are not changed with the conformal coating, whereas the thickness of the micro/nanofibers is slightly increased.

In the present invention, the tangled fibers form a porous layer, characterized in particular by its pore diameters. Said pore diameter is usually measured by X-ray and/or three-dimensional tomography. For instance, the acquisitions are carried out with the DeskTom machine model equipped with a generator. Adapting the parameters for image treatment is common in the art.

As used herein, "an electrical circuit of the Bennet family" is understood as an electrical circuit which performs charge accumulation on storage capacitors through repetitively switching the electrical connection between the said storage capacitors from parallel connection to serial connection and then vice versa.

### DETAILED DESCRIPTION

### 1. Electret film

### 1.1. Matrix Layer or Support Layer for the Conformal Coating

Preferably, the pores of the matrix layer have a diameter of between 0.5 and 10 µm.

Advantageously, the matrix layer is of 1 µm to 1 mm thick, preferably of 50 µm and 500 µm, for instance of 100 µm.

Advantageously, the fibers 11 are flexible. Preferably, the matrix layer is flexible as well.

The fibers 11 of the matrix layer may be of any type, with a diameter typically of between about 100 nm and about 100 µm. In a particular embodiment, the fibers are nanofibers. In another particular embodiment, the fibers are microfibers.

In a particular embodiment, the micro/nanofibers are textile micro/nanofibers.

In another particular embodiment, the micro/nanofibers 11 are polymeric, and advantageously flexible. In this embodiment, the micro/nanofibers 11 are advantageously electrospun (*i.e.* obtained by electrospinning) micro/nanofibers, preferably with a diameter of between about 100 nm to about 100 µm. **"Electrospinning"** is method for producing (polymeric) fibers well-known in the art. Electrospinning uses electric force to draw charged threads of polymer solutions or polymer melts, generally up to fiber diameters in the order of tens of nanometers, and shares characteristics of both electrospraying and conventional solution dry spinning of fibers.

Preferably, the fibers of the matrix layer are (electrospun) fibers of fluorinated and/or silylated polymer, and preferably mixtures thereof with auxiliary polymers.

Auxiliary polymers facilitate the preparation of a solution, in particular by formation of the solvent. Said auxiliary polymers increase the solubility of the said fluorinated and/or silylated polymer, and/or reduce the time required by the said fluorinated and/or silylated polymer to dissolve. Preferred auxiliary polymers are polyvinylpyrrolidone (PVP) and poly(methyl methacrylate) (PMMA).

For instance, fluorinated polymers are obtained from polymerizing one or several fluorinated monomers. Fluorinated monomers are for instance selected from the group consisting of tetrafluoroethylene (TFE), vinylidene fluoride (VDF), hexafluoropropylene, trifluoroethylene (TRFE), perfluoro(methyl vinyl ether), 3,3,3-trifluoropropene, 2,3,3,3-tetrafluoropropene, 1,3,3,3-tetrafluoropropene, chlorotrifluoroethylène, bromotrifluoroethylene, iodotrifluoroethylene, 2-chloro-3,3,3-trifluoropropene, vinyl fluoride, perfluoro(ethyl vinyl ether), perfluoro(propyl vinylether), 2-bromo-1,1-difluoroethylene, chlorodifluoroethylene, dichlorodifluoroethylene, 1,1,3,3,3-pentafluoropropene, 1,1,2,3,4,4-hexafluoro-1,3-butadiene, 1-propene, 1,1,3,3,3-pentafluoro-2-(trifluoromethyl)-l-propene or mixtures thereof. Advantageously, said fluorinated monomer is VDF, TFE, TRFE or mixtures thereof.

Preferred fluorinated polymers are PVDF (poly(vinylidene fluoride)), PTFE (poly(tetrafluoroethylene)), PTRFE (poly(trifluoroethylene)) and perfluoroalkoxy alkanes (PFA), such as copolymers of tetrafluoroethylene and perfluoroethers, in particular of formula C₂F₃ORf, with Rf is a perfluorinated group such as trifluoromethyl (CF₃), for example perfluoro(methyl vinyl ether), perfluoro(ethyl vinyl ether) and perfluoro(propyl vinylether). For instance, the preferred fluorinated polymers are PVDF and copolymers of tetrafluoroethylene and perfluoro(methyl vinyl ether).

A preferred silylated polymer is for instance polydimethylsiloxane (PDMS).

Particularly preferred polymeric fibers are PFA, PTFE, PVDF, PTRFE, PDMS, and mixtures thereof, in particular with PMMA and PVP. In particular, the polymeric fibers are PFA, PTFE, PVDF-PTFE, PVDF, PVDF-PVP, PDMS and PDMS-PMMA fibers.

### 1.2. Dielectric coating layer

The matrix layer may be entirely or partially coated with the dielectric conformal coating 3.

In a particular embodiment, the matrix layer is entirely coated with the dielectric conformal coating.

In another particular embodiment, the matrix layer is partially coated with the dielectric conformal coating.

Preferably, the matrix layer is coated with the dielectric coating on one or both longitudinal faces, preferably on one longitudinal face of the matrix layer (referred to as the upper face of the electret film).

The dielectric coating is adapted to store electrical charges, permanently or at least quasi-permanently. Advantageously, the dielectric conformal coating 3 is a polymer selected from poly(p-xylylene) polymers, Poly(methyl methacrylate) (PMMA), poly(vinylidene fluoride) PVDF, a fluorinated polymer such as polytetrafluoroethylene (PTFE, also known as Teflon^{®}), or amorphous fluoropolymers in particular of formula 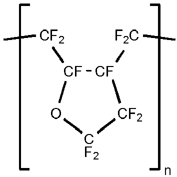 such as Cytop^{®}. Preferably, the dielectric coating is a poly(p-xylylene), wherein the p-xylylene monomer is optionally substituted, in particular by a chlorine atom. Advantageously, the polymeric coating is 0.5 to 50 µm thick, preferably 1 to 10 µm thick, for instance of 1 to 3 µm thick.

In a particular embodiment, the conformal dielectric coating 3 is deposited through chemical vapor deposition (CVD) or atomic layer deposition (ALD), preferably through CVD. In this embodiment, the dielectric coating is preferably a poly(p-xylylene), wherein the p-xylylene monomer is optionally substituted - also known as Parylene^{®} polymer. In particular, the dielectric coating is a poly(p-xylylene) polymer wherein the p-xylylene monomer is substituted a by a chlorine atom, such as Parylene C^{®}.

### 1.3. Electret Film

As explained above, the electret film 5a, 5b, 5c is compressible. In a particular embodiment, the electret film 5a, 5b, 5c is able to actively fully recover its initial form, after compressing, stretching and/or shearing. In another particular embodiment, the electret film 5a, 5b, 5c is able to only partially actively recover its initial form, after applying a mechanical force such as compressing, shearing or stretching. As explained above, the electret film 5a, 5b, 5c has a fibrous structure similar to that of the matrix layer, and is porous. There are spaces between the coated tangled fibers 12 (i.e. voids without matter), but the fibers are also into physical contact, thus creating pores within the coated tangled fibers 12. Preferably, the pores of the electret film 5a, 5b, 5c have a diameter of between 0.1 and 10 µm.

In addition, the electret film 5a, 5b, 5c may be qualified as a thin film. Typically, it is of 1 µm to 1 mm thick, preferably between 50 µm and 500 µm, for instance of 100 µm.

The electret film 5a, 5b, 5c is adapted to be permanently charged with negative and/or positive charges. The electrical charges are located in the dielectric conformal coating.

In a first embodiment, the electret film 5a, 5b, 5c is permanently charged with negative charges.

In a second particular embodiment, the electret film 5a, 5b, 5c is permanently charged with positive charges.

The aim of the invention is to load the film of coated tangled fibres 12 the more possible and therefore to cover the film of tangled fibres 11 with conformal coating 3 as much as possible, everywhere in the film, both in the surface and in the core of the film.

Preferably, in the first and second embodiments, the electrical charges (or dipoles) are located on at least one longitudinal surface of the electret film 5a, 5b, 5c which behaves as an electret (or piezo-electret) material.

Preferably, in the first and second embodiments, the electret film 5a, 5b, 5c is charged only on one face. In the case where the electret comprises the dielectric coating on only one longitudinal face (the 'upper face'), the electret film 5a, 5b, 5c is charged only on the 'upper face'.

In a third particular embodiment, electric dipoles are created inside the electret film which behaves as a piezo-electret material. In this embodiment, the electret film thus comprises both positive and negative charges, in other words it comprises dipoles.

### 1.4. External Coating or Hydrophobic Coating

In an advantageous embodiment, the electret film 5a, 5b, 5c further comprises an additional external (conformal) coating of hydrophobic material, such as a hydrophobic polymer or hydrophobic organic compound material. The further external coating limits the electret film discharge. In the following, the terms "external coating" and "hydrophobic coating" are used to designate the same external (conformal) coating of hydrophobic material.

Advantageously, the external coating is conformal, that is to say the electret film comprising the further external coating retains the fibrous structure of the matrix layer, and is porous.

Typically, the thickness of the external coating is between 1/100 and 1/10 of the thickness of the dielectric coating. For instance, the external coating is between about 1 nm and about 100 nm thick.

The electret film 5a, 5b, 5c may be entirely or partially coated with the hydrophobic coating. In a particular embodiment, the electret film is entirely coated with an external coating of hydrophobic material. In another particular embodiment, the electret film is partially coated with an external coating of hydrophobic material.

In a particular variant of this embodiment, the electret film is coated with dielectric coating on only one longitudinal face (the 'upper' face of the electret film). The longitudinal face not comprising the dielectric coating is the 'lower' face of the electret film. The hydrophobic coating may be on the 'upper' face, or on the lower face, or on both longitudinal faces.

In another variant of this embodiment, the electret film is coated with the dielectric coating on both longitudinal faces. The hydrophobic coating may then be on only one face or on both faces of the electret film.

Humidity is a possible cause of depolarization of the electret. Coating the electret film with the external coating on the charged face may help avoiding or delaying this phenomenon. In this embodiment, the electret film further comprises an external conformal coating of hydrophobic material in order to avoid electret film discharge, the hydrophobic material is for instance a fluorinated polymer or hexamethyldisilizane (HDMS), and said external coating layer is advantageously of between 10 nm and 100 nm.

Coating the electret film with the external coating on the lower face, thus creating a hydrophobic base layer, may be advantageous in case triboelectric generation is searched for.

Hydrophobic polymer materials suitable for the external coating are for instance fluorinated polymers. Hydrophobic organic compound material suitable for the external coating is for instance hexamethyldisilizane (HDMS).

Examples of suitable fluorinated polymers are polymers obtained from polymerizing one or several fluorinated monomers selected from the group consisting of tetrafluoroethylene (TFE), vinylidene fluoride (VDF), hexafluoropropylene, trifluoroethylene (TRFE), perfluoro(methyl vinyl ether), 3,3,3-trifluoropropene, 2,3,3,3-tetrafluoropropene, 1,3,3,3-tetrafluoropropene, chlorotrifluoroethylène, bromotrifluoroethylene, iodotrifluoroethylene, 2-chloro-3,3,3-trifluoropropene, vinyl fluoride, perfluoro(ethyl vinyl ether), perfluoro(propyl vinylether), 2-bromo-1,1-difluoroethylene, chlorodifluoroethylene, dichlorodifluoroethylene, 1,1,3,3,3-pentafluoropropene, 1,1,2,3,4,4-hexafluoro-1,3-butadiene, 1-propene, 1,1,3,3,3-pentafluoro-2-(trifluoromethyl)-1-propene or mixtures thereof. Advantageously, said fluorinated monomer is VDF, TFE, TRFE or mixtures thereof. Preferred fluorinated polymers are PVDF (poly(vinylidene fluoride)), PTFE (poly(tetrafluoroethylene)), PTRFE (poly(trifluoroethylene)) and perfluoroalkoxy alkanes (PFA), such as copolymers of tetrafluoroethylene and perfluoroethers, in particular of formula C₂F₃ORf, with Rf is a perfluorinated group such as trifluoromethyl (CF₃), such as perfluoro(methyl vinyl ether), perfluoro(ethyl vinyl ether) and perfluoro(propyl vinylether). For instance, the preferred fluorinated polymers are PVDF and copolymers of tetrafluoroethylene and perfluoro(methyl vinyl ether).

Particularly preferred the hydrophobic material is PTFE or PVDF, more preferably PTFE.

An example of hydrophobic organic compound material suitable for the external coating is for instance hexamethyldisilizane (HDMS).

### 1.5. Advantageous embodiments

In an advantageous embodiment, the compressible porous electret film comprises:
- a layer of coated tangled polymeric, electrospun, micro/nanofibers 12,
- said layer of tangled micro/nanofibers being coated with a conformal dielectric coating 3 able to store electrical charges, said dielectric coating being permanently (or quasi permanently) charged.

In this advantageous embodiment, the polymeric fibers are typically PFA, PTFE, PVDF, PTRFE, PVDMS and mixtures thereof in particular with PVP and/or PMMA, such as PFA, PTFE, PVDF-PTFE, PVDF, PVDF-PVP, PDMS and PDMS-PMMA fibers.

In this advantageous embodiment, the dielectric conformal coating 3 is preferably a poly(p-xylylene), wherein the p-xylylene monomer is optionally substituted, in particular by a chlorine atom, and the dielectric coating is typically deposited through CVD. Advantageously, the polymeric coating is 0.5 to 50 µm thick, preferably 1 to 10 µm thick, for instance of 1 to 3 µm thick. In this case, the dielectric coating (when charged) is negatively charged.

Advantageously, the electret film further comprises an external (conformal) coating of hydrophobic material, such as a hydrophobic polymer material as described above in 1.4, preferably PTFE or PVDF, more preferably PTFE.

### 1.6. Combinations

All combination of general or particular and/or preferred embodiments of the electret film are encompassed by the invention.

### 2. Process for preparing the electret film

The process for preparing the electret film comprises a step a) of depositing a dielectric conformal coating 3, in particular through chemical vapor or atomic layer deposition, on a layer of micro/nanofibers tangled 11, thus leading to a non-charged electret film 12. The dielectric conformal coating 3 is deposited on one or both longitudinal faces of the film of micro/nanofibers tangled 11. In case the dielectric coating is deposited on only one longitudinal face, this face is called the 'upper face', while the opposite 'uncoated' face is referred to as the 'lower' face.

The non-charged electret film is then charged with a quantity of charges, if possible the greatest quantity of charges.

The layer of tangled micro/nanofibers 11 and the dielectric conformal coating 3 are as described above in 1, and in particular in 1.1, 1.2, 1.3 and 1.5. Of note, the dielectric conformal coating 3, in particular when obtained through CVD, is conformal.

In a particular embodiment, the process further comprises a step b) of applying an external coating 4 of hydrophobic material on top of the dielectric coating before or after having charged the conformal coating 3, for instance through plasma deposition, chemical vapor deposition or atomic layer deposition, preferably plasma deposition. The hydrophobic material is preferably as described above in section 1.4. Preferably, the external coating 4 is also conformal. The hydrophobic coating 4 may be deposited on either or both longitudinal faces.

When a charged electret is sought for, the process further comprises a step c) of charging the non-charged electret film optionally comprising an external coating and/or a base coating by ionizing the air in the vicinity of the dielectric coating and/or within the non-charged electret film, for example by applying a corona discharge or X-ray irradiation on the dielectric coating. Step c) is typically performed after step a) (and optional step b) if applicable).

As known in the art, a **"Corona Discharge"** is an electrical discharge brought on by the ionization of a fluid such as air surrounding a conductor that is electrically charged. A corona discharge occurs when the strength of the electric field (potential gradient) around a conductor is high enough to form a conductive region, but not high enough to cause electrical breakdown or arcing to nearby objects. It is often seen as a bluish (or other colour) glow in the air adjacent to pointed metal conductors carrying high voltages, and emits light by the same property as a gas discharged lamp. The person of skill in the art will adapt the corona Discharge parameters so as to reach the desired level of charge in the electret film. The voltage on the pointed metal conductor is typically between 10kV and 20kV. A grid voltage - typically between 10V and 1kV - is connected to a grid-shaped metal electrode, so as to uniformly deposit the ionized fluid on top of the said electric film. For instance, a Corona discharge of with the said point voltage of 12 kV and the said grid voltage of 500V is performed. Preferably, the Corona Discharge is carried out at a temperature of between 50°C and 200°C, more preferably between 80°C and 150°C. In any case, the Corona Discharge is performed at a temperature below the fusion point of the glass transition temperature of the fibers and dielectric coating.

In case it is desired to charge the electret film with only positive charges, or only negative charges, the Corona discharge is applied essentially in the vicinity of the dielectric coating, or typically 1-20 cm, preferably 5-10 cm, above the dielectric coating. In case it is desired to obtain electric dipoles, the Corona discharge is applied within the matrix layer, and/or within the dielectric coating.

When X-ray irradiation is used, the conditions are selected by the person of skill in the art so as to generate the desired electrical charges, however, without degrading the film. For instance, the person of skill in the art will chose conditions known as "soft X-ray irradiation".

The electrical charge typically stabilizes to its final level within 24 hours after step d). The charged thus obtained (after stabilization) is permanent, or at least quasi permanent.

In a particular embodiment, the process comprises the successive steps a) and c), or a), b) and c).

In a particular embodiment, the process comprises, before step a), a step of preparing the layer of tangled micro/nanofibers, in particular by electrospinning, as exposed in particular above in 1.1.

All combination of general or particular and/or preferred embodiments of each steps are encompassed by the process.

### 3. Electrostatic transducer

The capacitance of the electrostatic transducer is minimal (Cₘᵢₙ) in the released position, and maximal (Cₘₐₓ) in the strained position. This working principle is illustrated in figure 3 (embodiment wherein the electrodes A, B are compressed), figure 4 (embodiment wherein the electrodes A, B are sheared) and figure 5 (embodiment wherein the electrodes A, B are stretched).

The overall performance of the electrostatic transducer is a function of the quantity of charge in the electret and of the ratio Cₘₐₓ/Cₘᵢₙ. Therefore, it is possible to improve the performance of the electrostatic transducer either by increasing the Cₘₐₓ value, or by decreasing the Cₘᵢₙ value, or by increasing the quantity of charge in the electret material.

### 3.1. Electret film and mats

The electret film 5a, 5b, 5c may be as described above in 1. Preferably, the electret film5a, 5b, 5c is flexible.

In a particular embodiment, the electrostatic transducer comprises at least two, and preferably at most 10 electret films 5a, 5b, 5c. Preferably, the electrostatic transducer comprises 3 or 4 electret films 5a, 5b, 5c.

In a first variant, the electret film 5a, 5b, 5c is charged on only one longitudinal face (the 'upper face'), while the opposite longitudinal face (the 'lower face') is not charged. The electret films 5a, 5b, 5c are then preferably arranged so that the upper face of a given electret film faces the lower face of the following electret film.

In a second variant of this embodiment, the matrix layer 11 of each of the electret film 5a, 5b, 5c is coated on only one longitudinal face with the dielectric layer (the 'upper face', which also corresponds to the charged face), and the electret films 5a, 5b, 5c are preferably arranged so that the upper face of a given electret film faces the lower face of the following electret film.

In a third variant of this embodiment, the electret film 5a, 5b, 5c is charged on both longitudinal faces. In a forth variant of this embodiment, the matrix layer 11 of each of the electret film 5a, 5b, 5c is coated then charged on both longitudinal faces with the dielectric.

In a particular embodiment, several stacked electret films 5a, 5b, 5c, thus forming a mat 5, are arranged between the two electrodes A, B. In a mat of electret films 5a, 5b, 5c, each film is into physical contact with at least one other film. In this embodiment, at least two, and preferably at most 10 electret films 5a, 5b, 5c are stacked, thus forming a mat arranged between the two electrodes A, B. Preferably, 3 or 4 electret films 5a, 5b, 5c are stacked, thus forming a mat arranged between the two electrodes A, B.

In embodiments comprising several electret films 5a, 5b, 5c, the quantity of charge in the electrostatic transducer is increased, thus improving its performance. In these embodiments, the number of (stacked) electret films 5a, 5b, 5c is selected to optimize the collected electrical power. Preferably, the distance between the electrodes A, B and the electret films 5a, 5b, 5c is also selected to optimize the collected electrical power (by decreasing the Cₘᵢₙ value).

In a particular embodiment, the electrostatic transducer comprises several stacked electret films 5a, 5b, 5c forming a mat 5, the number of stacked electret films 5a, 5b, 5c and the distance separating the electrodes A, B and electret films 5a, 5b, 5c being selected to optimize the collected electrical power.

In a particular embodiment, all the electret films 5a, 5b, 5c have the same type of charges, i.e. they are all positively charged or negatively charged.

In another particular embodiment, the electrostatic transducer comprises at least two electret films 5a, 5b, 5c, arranged so as to alternate the sign of their charge. For instance, the electrostatic transducer comprises 4 electret films 5a, 5b, 5c, wherein the first is positively charged, the second is negatively charged, the third is positively charged and the fourth is negatively charged. Such an arrangement creates dipoles, and the overall electret comprising the at least two films (either stacked or not) forms a piezoelectret.

In another particular embodiment, all the electret films 5a, 5b, 5c are charged with dipoles. In this embodiment, the overall electret comprising at least one film forms a piezoelectret.

### 3.2. Electrodes A, B

Advantageously, at least one of the electrodes A, B is flexible. Preferably, all the electrodes A, B are flexible. For instance, the electrode may itself be a film, a paper or a tape, typically metallic or coated with a metallic coating.

The electrodes A, B comprise at least a conductive material, and may be identical or different. In a particular embodiment, the electrodes A, B comprise a material selected from carbon, copper iridium oxide, cobalt oxide, cobalt phosphate, stainless steel or platinum electrode, for example it is a carbon, copper, iridium oxide, cobalt oxide or platinum electrode. Preferably, the electrode (A and/or B) is a carbon or a copper electrode (such as a copper film).

If appropriate, the electrodes A, B are electrically insulated so as to avoid any short-circuit, for instance by direct contact between the conductive part of the two electrodes A, B (see Figure 9c). Advantageously, at least one electrode B is coated, at least partially, with an intermediate (electrically) insulating layer 6, located on the part of the electrode which is into physical contact with the electret film or mat of electret films 5a, 5b, 5c when the electrodes A, B are in the strained position. The intermediate insulating layer 6 is aimed at preventing triboelectric charge generation of the same polarity on both electrodes A, B at the same time. The intermediate insulating layer thus faces the electret film and covers a part of the electrode B sufficient to prevent any physical contact between the electret film or the mat of electret film and the electrode.

The intermediate insulating layer 6 is for instance a layer of electrically isolating material such as the dielectric coating of the coating layer of the electret film as described in 1.2, or the hydrophobic material of the external coating layer of the electret film as described in 1.4. It may also be of the same material as the dielectric coating layer described above in 1.2.

### 3.3. Individual support of the electrode

In a particular embodiment, at least one of the electrodes A, B is fitted or deposited on a flexible individual support 7.

In a particular embodiment, the flexible support is curved or presents a curved shape.

### 3.4. Spatial arrangements

The electrostatic transducer may have different spatial arrangements.

In another particular embodiment, at least one electret film or mat of electret films 5a, 5b, 5c is into physical contact with at least one electrode when the electrodes A, B are in the released position.

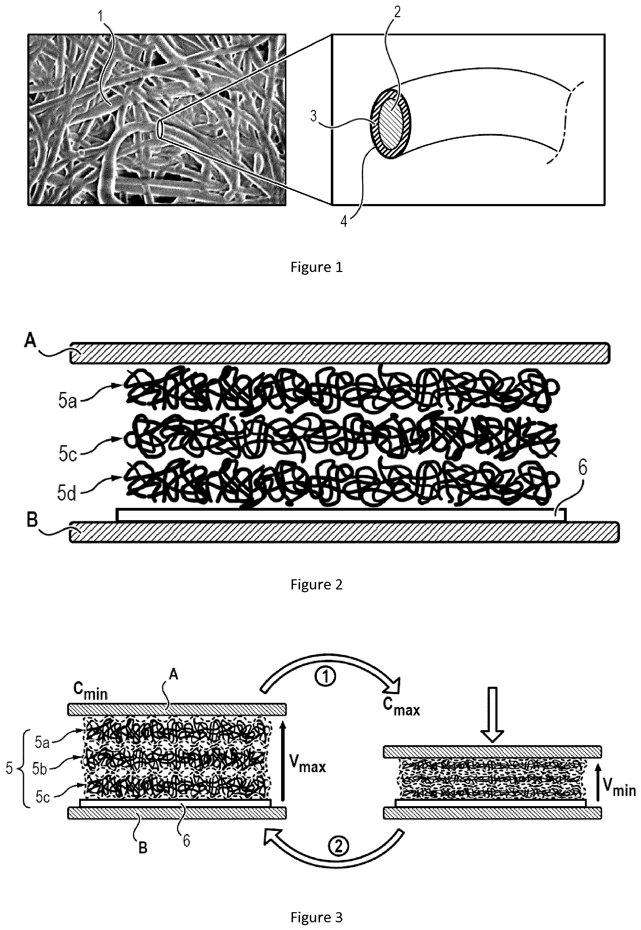

In a particular embodiment, at least one (preferably flexible) electret film 5a, 5b, 5c is mounted between the electrodes A, B without spaces between the electrodes A, B and the electret film(s) 5a, 5b, 5c. In this embodiment, said at least one electret film is into physical contact with the two electrodes A, B when the electrodes A, B are in the released position (and in the strained position). In a particular embodiment, a mat of (preferably flexible) electret films 5a, 5b, 5c is mounted between the electrodes A, B without spaces between the electrodes A, B and the electret film(s) when the electrodes A, B are in the released position. In this embodiment (illustrated in Figure 2), the mat is into physical contact with the two electrodes A, B when the electrodes A, B are in the released position.

In some embodiments, the electrostatic transducer comprises one or several air layers when the electrodes A, B are in the released position, for instance between the electret film(s) or mat(s) of electret films 5a, 5b, 5c and at least one electrode, and/or between two adjacent electret films 5a, 5b, 5c or mat(s) 5 of electret films 5a, 5b, 5c. In these embodiment, and in particular in the following five embodiments, the air gaps (or air layer(s)) are advantageously created thanks to mechanical means, such as springs and/or elastic spacers, in particular when the electret film 5a, 5b, 5c is able to only partially recover its initial shape or very slowly recovers its full initial shape after being subjected to a mechanical force (such as compressing, stretching and/or shearing). In these embodiments, and in particular in the following five embodiments, the distance between the electrodes A, B and electret films 5a, 5b, 5c (or mats of electret films 5a, 5b, 5c) is selected to optimize collected electrical power, in particular by decreasing the Cₘᵢₙ value.

In a first embodiment, several stacked electret films 5a, 5b, 5c or mats 5 of electret films 5a, 5b, 5c are arranged between the two electrodes A, B so that there are air gaps (or air layer(s)) when the mechanical force is released, said air gaps (or air layer(s)) being either between the electrodes A, B, between the electret film(s) and the electrode, and/or between two adjacent electret films 5a, 5b, 5c.

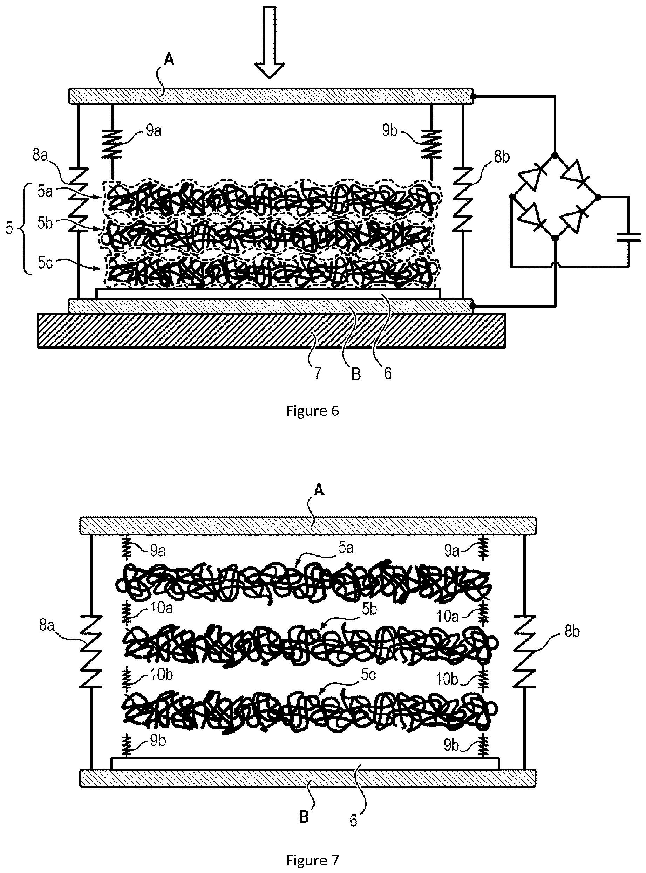

In a second particular embodiment, at least one electret film 5a, 5b, 5c, or mat 5 of electret films 5a, 5b, 5c is into physical contact with only one electrode when the electrodes A, B are in the released position. Typically, air gaps (or air layer(s)) are present between electret film(s) and the electrode when the electrodes A, B are in the released position. For instance, the electrostatic transducer may consist of one mat 5 of electret films 5a, 5b, 5c arranged between two electrodes A, B (one of which (B) may be coated with an intermediate insulating layer as described above in 3.2), wherein said mat 5 is into physical contact with only one electrode (preferably the electrode B coated with the intermediate isolating layer) when the electrodes A, B are in the released position. Such an embodiment is for example illustrated in Figure 6.

In a third particular embodiment, at least one electrode is not into physical contact with (any of) the electret film(s) or mat(s) of electret films 5a, 5b, 5c when the electrodes A, B are in the released position. Typically, air gaps (or air layer(s)) are present between the electrodes A, B and between electret film(s) and the electrode when the electrodes A, B are in the released position. Such an embodiment is for example illustrated in Figure 7.

In a fourth embodiment, the electrostatic transducer comprises at least two adjacent electret films 5a, 5b, 5c (or two adjacent mats of electret films 5a, 5b, 5c), which are not into physical contact when the electrodes A, B are in the released position. Typically, air gaps (or air layers) are present between the two adjacent electret film(s) when the electrodes A, B are in the released position. Such an embodiment is for example illustrated in Figure 7.

In a fifth particular embodiment, the electret film 5a, 5b, 5c, or the mat 5 of electret films 5a, 5b, 5c is arranged between the two electrodes A, B, so as to be closer to one electrode than to the other electrode in the released position. In another embodiment, the electrostatic transducer comprises several electret films 5a, 5b, 5c or the mats of electret films 5a, 5b, 5c, and there are more electret films 5a, 5b, 5c or mats closer to one electrode than to the other electrode in the released position.

### 3.5. Interdigitated comb

In a particular embodiment, the transducer comprises more than one pair of electrodes (A, A', B, B'). In this embodiment, the electrostatic transducer thus comprises an even number of electrodes.

In particular, the electrostatic transducer may be an interdigitated comb, with each digit comprises an electrode and an electret film or mat of electret.

The digits of the interdigitated comb may be identical or different.

Each section of the interdigitated comb, comprising two electrodes A, A' and an electret film or mat of electret films 5a, 5b, 5c 5 arranged between the two electrodes A, A', may have any of the spatial arrangement described above in 3.4.

In particular, each electrode is preferably coated on only one longitudinal face with an electrically insulated coating as described above in 3.1. Preferably, the electret film comprises a matrix layer coated only on one longitudinal face with a dielectric coating, and the coated face of the electrode A' faces the face of the electret film opposite the face comprising the dielectric coating *(i.e.* the coated face of electrode A' faces the lower face of the electret film).

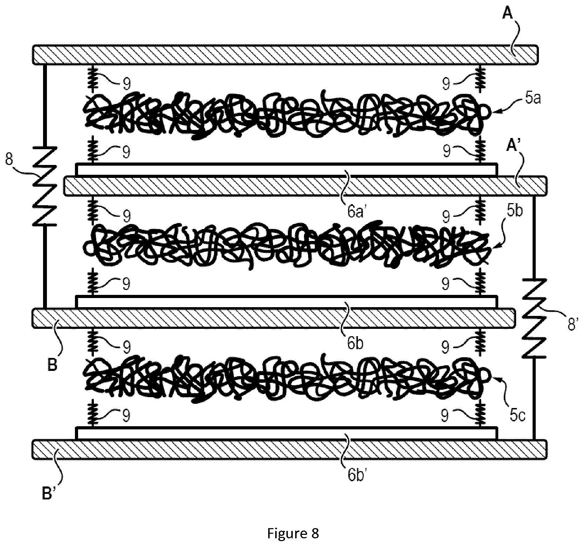

The interdigitated comb may in particular be as described below in connection with Figure 8.

### 3.6. Preventing depolarization of the electret film over time

As explained above, electrets may depolarize over time, in particular depending on environmental conditions such as humidity and temperature. However, depolarization (loss of charges) may be avoided, or at least delayed, for instance by combining the electrostatic transducer with a self-biasing conditioning circuit like a capacitive-loaded rectifier or an electrical circuit of the Bennet doubler family, or by taking advantage of triboelectric charging.

In a first advantageous embodiment, the electrostatic transducer is connected through its electrodes A, B to a self-biasing conditioning circuit like a capacitive-loaded rectifier or an electrical circuit of the Bennet doubler family. For example, the self-biasing conditioning circuit comprises a diode bridge (a bridge rectifier) and a capacitor.

Triboelectric charging is a type of contact electrification in which certain materials become electrically charged after they come into frictional contact with a different material (such as for instance when rubbing glass with fur). In another advantageous embodiment, the electret film or mat of electret films 5a, 5b, 5c and the electrodes A, B are arranged to create triboelectric charging.

In this embodiment, at least a longitudinal surface which is charged of the electret film is at the opposite to a given electrode into physical contact with the electret film or mat of electret films 5a, 5b, 5c when the electrodes A, B are in the strained position so as to charge the other longitudinal surface of the electret film which is in contact with the given electrode by triboelectricity in the strained position. Preferably, in this embodiment, the first electrode A, which is into physical contact with the electret film or mat of electret films 5a, 5b, 5c when the electrodes A, B are in the strained position, is not coated with an intermediate insulating layer. The second electrode B is coated, at least partially, with an intermediate (electrically) isolating layer 6 (as described above in 3.2). The intermediate insulating layer is aimed at preventing triboelectric charge generation of the same polarity on both electrodes A, B at the same time. The intermediate insulating layer thus covers a part of the electrode B sufficient to prevent any physical contact between the electret film or the mat of electret film and the electrode B.

In this embodiment, the matrix layer of the electret film 5 may be coated on only one longitudinal face with the dielectric layer (the 'upper face' of the electret film). In this case, the 'upper face' of the film is the charged face of the film. The matrix layer of the electret film may also be coated on both longitudinal faces, but is charged on only one longitudinal face (the 'upper face').

In a first structure of this embodiment, the charged face of the electret film (1) faces the uncoated electrode A, so as to charge the charged face of the electret film in contact with the said electrode A by triboelectricity, in the strained and/or released position.

In this first structure, the electret film is typically coated with an external coating of hydrophobic material (such as PTFE and HDMS) on the longitudinal face of the electret film which is not charged (in some embodiments, the 'uncharged face' of the electret film does not comprise any dielectric coating). In other words, in this first structure, electrode A faces the charged longitudinal face of the electret, while the 'lower face' of the electret (comprising the external coating of hydrophobic material, such as PTFE and HDMS) faces electrode B.

In a second structure of this embodiment, the charged face of the electret film (1) faces the coated electrode B, so as to charge the other longitudinal surface of the film in contact with the uncoated electrode A by triboelectricity, in the strained and/or released position. In this second structure, the longitudinal face which is charged by triboelectricity (in the strained and/or released position) is the uncharged face of the electret film. In this embodiment, the insulating layer 6 of electrode B is preferably a polymer selected from poly(p-xylylene) polymers, Poly(methyl methacrylate) (PMMA), poly(vinylidene fluoride) PVDF, a fluorinated polymer such as polytetrafluoroethylene (PTFE, also known as Teflon^{®}), or amorphous fluoropolymers in particular of formula 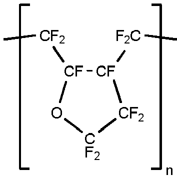 such as Cytop^{®}.

Preferably, the dielectric coating is a poly(p-xylylene), wherein the p-xylylene monomer is optionally substituted, in particular by a chlorine atom.

When the electrostatic transducer comprises several electret films 5a, 5b, 5c or mats of electret films 5a, 5b, 5c, each electret film is charged on only one longitudinal face. In this embodiment, the electret films 5a, 5b, 5c alternate so that the charged longitudinal face of a first electret film faces the uncharged face of the second electret film (i.e. the face of the second electret film opposite the charged face). Such an arrangement allows charging the longitudinal face of the electret film coming into physical contact with the electrode upon applying mechanical force, with triboelectricity.

### 3.6 Particular embodiments

Particular embodiments are showed in Figures 2 to 8.

Figure 2 represents an embodiment of the electrostatic transducer comprising 2 electrodes A, B (A) and (B), three stacked electret films 5a, 5b, 5c of the invention (5a), (5b) and (5c) forming a mat (5), arranged between the two electrodes A, B . One of the electrodes (electrode B) is coated with an electrically insulating layer (6), to prevent triboelectric effect. The electrically insulating layer (7) faces the mat (5). The electrostatic transducer of Figures 3-5 is the same as the one represented in Figure 2. (A), (B), (5), (5a), (5b), (5c) and (6) thus have the same meaning as in Figure 2. Of note, the dotted lines around each electret film (5a), (5b) and (5c) are only meant to help visualize each individual electret film in the mat, but do not correspond to a real physical entity.

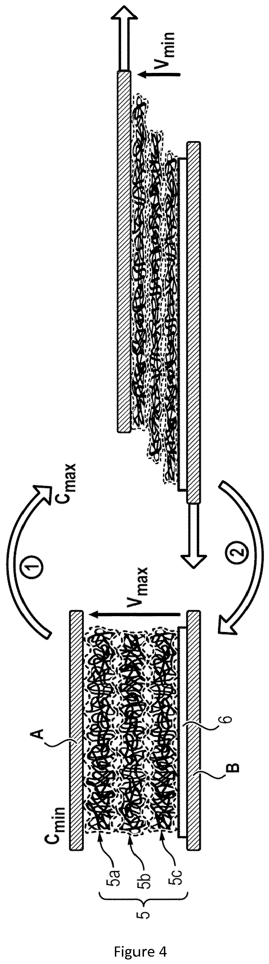

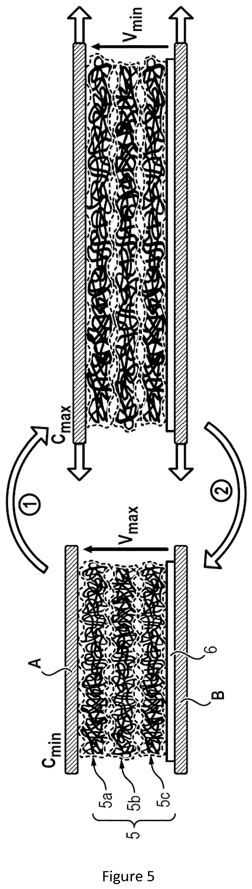

On the left side of each of Figures 3-5, the electrostatic transducer is in the released position: the capacitance value is then Cₘᵢₙ, and the voltage between the two electrodes A, B is at its lowest value Vₘᵢₙ. On the right side of each of Figures 3-5, the electrostatic transducer is in the strained position: the capacitance value is then Cₘₐₓ, and the voltage between the two electrodes A, B is at its highest value Vₘₐₓ. In figure 3, the capacitance variation is obtained by compressing the electrostatic transducer. In figure 4, the capacitance variation is obtained by shearing the electrostatic transducer. In figure 5, the capacitance variation is obtained by stretching the electrostatic transducer.

Figure 6 represents an embodiment of the electrostatic transducer comprising 2 electrodes A, B , three stacked electret films 5a, 5b, 5c of the invention forming a mat 5, arranged between the two electrodes A, B . One of the electrodes A is fitted on a support 7. The electrode (B, the lower electrode) is coated with an electrically insulating layer 6, to prevent triboelectric effect. The electrically insulating layer 6 faces the mat 5. The mat 5 and the electrically insulating layer 6 of electrode B are into physical contact even in the released position.

Of note, the dotted lines around each electret film 5a, 5b and 5c are only meant to help visualize each individual electret film in the mat (5), but do not correspond to a real physical entity.

In the embodiment of Figure 6, the electret films 5a, 5b, 5c (are able to only partially actively recover their initial form, when subjected to compressing. The electrostatic transducer of Figure 6 thus further comprises springs or elastic spacers (8a and 8b) connected to the two electrodes A, B, and springs or elastic spacers (9a and 9b) connected to the upper electrode (the uncoated electrode (A)) and the mat. Said springs or elastic spacers (8a, 8b, 9a and 9b) enable the mat as well as the whole transducer to fully recover their initial shape after compressing.

The electrostatic transducer of Figure 6 further comprises an electrical circuit connected to the two electrodes A, B (A, B). The electrical circuit is for instance a capacitive-loaded rectifier or an electrical circuit of the Bennet doubler family. In Figure 6, the electrical circuit comprises a diode bridge (a bridge rectifier), connected to a capacitor.

Figure 7 represents an embodiment of the electrostatic transducer comprising 2 electrodes A, B, three electret films 5a, 5b, 5c of the invention, arranged between the two electrodes A, B. In this embodiment, the electret films 5a, 5b, 5c (are individualized (i.e. they are not stacked), separated by and air layer. Moreover, the electret films 5a, 5b, 5c are not in physical contact with the electrodes A, B, *i.e.* there is an air layer between electret film 5a and electrode A on the one hand, and an between electret film (5b) and electrode (B) on the other hand, in the released position.

The electrode B (the lower electrode) is coated with an electrically insulating layer (6), to prevent triboelectric effect. The electrically insulating layer 6 faces the mat 5.

In the embodiment of Figure 7, the electret films 5a, 5b, 5c are able to only partially actively recover their initial form, when subjected to compressing. The electrostatic transducer of Figure 7 thus further comprises springs or elastic spacers (8a and 8b) connected to the two electrodes A, B. It further comprises springs or elastic spacers (9a and 9b) connected to the upper electrode (the uncoated electrode) (A) and the first electret film 5b and to the lower electrode (the coated electrode) (B) and the third electret film 5c respectively, and springs or elastic spacers (10a, 10b) connected between the first and the second electret film on the one hand, and between the second and the third film on the other hand. Said springs or elastic spacers (8a, 8b, 9a, 9b, 10a, 10b) enable the electret films 5a, 5b, 5c as well as the whole transducer to fully recover their initial shape after compressing.

Figure 8 represent an embodiment wherein v is an interdigitated comb. In this embodiment, the electrostatic transducer comprises 4 electrodes (A, B, A' and B'), three electret films 5a, 5b, 5c of the invention, each arranged between two electrodes: electret film (5a) is between electrodes (A) and (A'), electret film 5b is between electrodes (A') and (B), and electret film 5c is between electrodes A, B (B) and (B').

In this embodiment, the electret films 5a, 5b, 5c are individualized (i.e. they are not stacked), separated by and air layer. Moreover, the electret films 5a, 5b, 5c are not in physical contact with the electrodes A, B, *i.e.* there is an air layer between electret film (5a) and electrodes (A) and (A'), and between electret film 5b and electrodes (A') and (B), and between electret film 5c and electrodes (B) and (B').

Electrodes (A'), (B) and (B') further comprises an intermediate electrically isolating layer (6'a, 6b and 6'b), coated on one side (the upper side) of each electrode (A'), (B) and (B'), to prevent triboelectric effect.

In the embodiment of Figure 8, the electret films (5a), (5b) and (5c) are able to only partially actively recover their initial form, when subjected to compressing. The electrostatic transducer of Figure 7 thus further comprises springs or elastic spacers (8 and 8') connected to electrodes A, B on the one hand, and to electrodes (A') and (B') on the other hand. In addition, each electret film (5a, 5b, and 5c) is connected to the two electrodes between which it is arranged through springs or elastic spacers (9). Said springs or elastic spacers (8, 8' and 9) enable the electret films 5a, 5b, 5c as well as the whole transducer to fully recover their initial shape after compressing.

### 3.7. Process for preparing the electrostatic transducer

The electrostatic transducer may be prepared by a process comprising the following successive steps:
a) providing a first electrode,
b) providing an electret film as described herein or mat of electret films 5a, 5b, 5c of the invention, and
c) providing a second electrode, so that the electret film of the invention or mat of electret films 5a, 5b, 5c of the invention is arranged between the two electrodes A, B, for instance through a microfabrication process.

In a particular embodiment, the electrostatic transducer may be prepared by a process comprising the following successive steps:
a) providing a first electrode,
b) providing a non-charged electret film as described herein on a conductive material layer arranged onto the electrode of step a),
c) charging said non-charged electret film for instance by applying a corona discharge or X-ray irradiation, thus leading to the charged electret film of the invention, and
d) providing a second electrode arranged onto the film of step b).

In a particular embodiment, step b) comprises coating the electret film of the invention onto the first electrode.

In a particular embodiment, steps b) and c) are repeated.

### BRIEF DESCRIPTION OF THE DRAWINGS

Figure 1. Figure 1a shows a SEM (Scanning Electron Microscopy) photograph of the electret film of the example. Figure 1b shows a schematic representation of the structure of a fiber 1 at the surface of the electret film: at the surface, the fiber core (2), is coated with a dielectric coating (3), and further comprises an external hydrophobic coating (4).
Figure 2. Schematic representation of an embodiment of the electrostatic transducer comprising three stacked electret films 5a, 5b, 5c.
Figure 3. Schematic representation of the released position (left) and strained position (right) of the electrostatic transducer, when the capacitance variation is obtained through compressing.
Figure 4. Schematic representation of the released position (left) and strained position (right) of the electrostatic transducer, when the capacitance variation is obtained through shearing.
Figure 5. Schematic representation of the released position (left) and strained position (right) of the electrostatic transducer, when the capacitance variation is obtained through stretching.
Figure 6. Schematic representation of an embodiment of the electrostatic transducer, wherein it is connected to an electrical circuit, comprising a diode bridge (a bridge rectifier) connected to a capacitor.
Figure 7. Schematic representation of an embodiment of the electrostatic transducer, wherein it further comprises elastic means or springs.
Figure 8. Electrostatic transducer as interdigitated comb.
Figure 9. Schematic (a), photograph (b), and working principle (c) of the paper-based low-frequency e-KEH of the example.
Figure 10. SEM Photograph of the electrospun nanofiber of PVDF/PTFE before (a) and after (b) CVD deposition of Parylene C. The fibers of b correspond to the coated fibers 1.

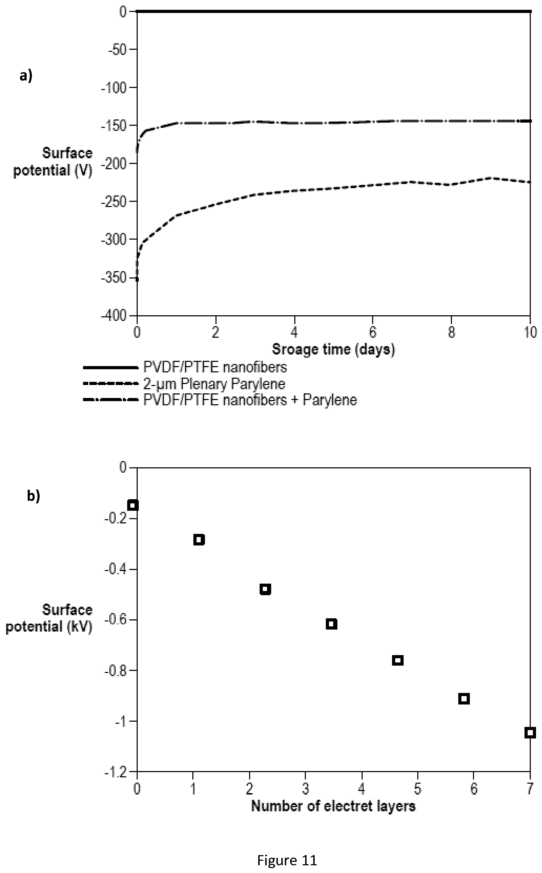

Figure 11. (a) Surface potential evolution of single-layer nanofibrous film after corona charging with and without parylene C. (b) Initial surface potential of stacked multi-layered nanofibrous electret.

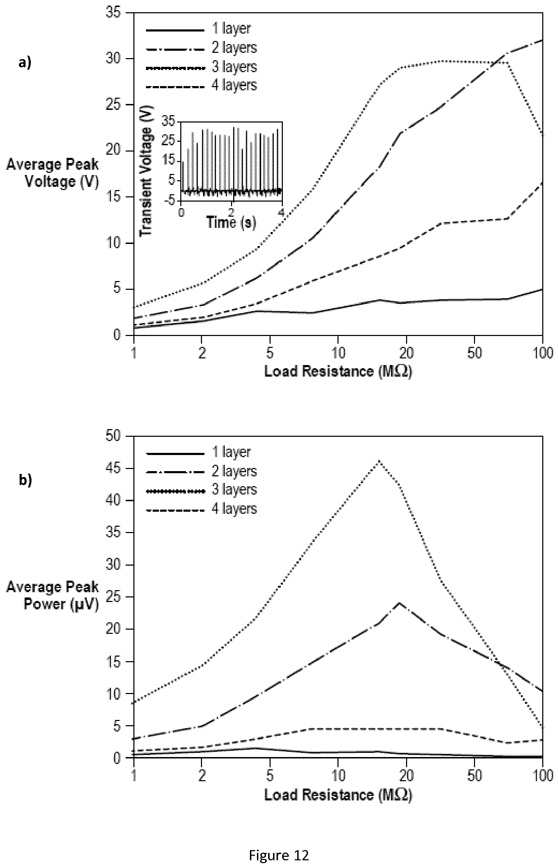

Figure 12. (a) Average peak voltage and (b) power with sweeping load. The inset plot in (a) is the transient output voltage when the device is working with the optimal configuration (3 layers of thin film electret, with the load of 16 MΩ), corresponding to the peak power of 45.6 µW.

The present invention is further illustrated by the following example, which is not to be construed as limiting the scope of the invention in any way.

### EXAMPLE

### 1. Example of electrostatic transducer according to the invention

A flexible nanogenerator using multi-layered nanofibrous electret as the electrostatic source has been prepared. The electret material is based on electrospun nanofibers with a thin layer of Parylene C, providing charge storage stability even better than plenary Parylene films. The device of the present example has a simple sandwich structure, and gives a maximum peak power of 45.6 µW. The design is light-weighted and is less than 1mm in thickness.

### 2. Device geometry

A schematic and a photograph of the proposed device are shown in Figure 9. The device has a sandwich structure with top and bottom electrodes A, B of copper tapes sticking on paper. Between the two electrodes A, B is a foam-like structure - a stack of negatively-charged nanofibrous films. The working principle of the device is shown in Figure 9(c). By applying a mechanical force on the electrodes A, B, the gaps between the nanofibrous films reduce and the capacitance of the device changes. Consequently, the distribution of the induced charges in the two electrodes A, B varies, according to the principle of the electrostatic transduction [6].

### 3. Material preparation

### 3.1. Preparation of nanofibrous electret

The nanofibrous films are fabricated from PVDF/PTFE solution through electrospinning. The component of the solvent is acetone and DMF with the volume ratio of 1:1 at room temperature (weight ratio 1:1.32), while the weight ratio of PVDF and PTFE is 5:1. The total weight proportion of the polymers in the solution is 18%. To prepare the solution, the 2 solvents are mixed by magneto stirring method at 60 °C for 30 min, and the powder of the 2 polymers are put into the solvent and stirred for 24 h at the constant temperature of 60 °C. The stirring speed is 50 rpm.

During the electrospinning process, the distance between the point and the receiver electrodes A, B is 15 cm, where the receiver is grounded and the high voltage of 13 kV is applied at the point electrode. The supply rate of the solution is 0.7 mL/h, and the electrospinning process lasts for 2h in total. The nanofibrous materials obtained are then processed by an additional deposition of Parylene C through Chemical Vapor Deposition process. Shown in Figure 10 are the microscopic photographs of the electrospun nanofibers before and after Parylene C deposition. As illustrated on the figure 10a, the pores result from the entanglement of the micro/nanofibers which exists between the tangled micro/nanofibers not coated (before the coating with the dielectric conformal coating). The entanglement of the tangled micro/nanofibers is different after the coating (several micro/nanofibers can be coating together with the dielectric conformal coating and/or can have changed of position in the tangled coating structure), as represented in the differences of tangled structure shown between figure 10a and figure 10b, but the structure of the entanglement with important spaces or voids without matter, is maintained with the tangled coating structure of the nano/micro fibers.

The elongated shape of the micro/nano fibers are not changed with the conformal coating, whereas the thickness of the micro/nanofibers is slightly increased.

### 3.2. Precharging

The electret films 5a, 5b, 5c are then charged by corona discharge at 12 kV/ 500 V/ 90 °C for 30 min. In Figure 11a, the comparison of the surface potential decay after corona charging are made between different materials:
a) plenary Parylene C film,
b) bare PVDF/PTFE nanofiber, c) PVDF/ PTFE nanofiber with Parylene C on top.

Despite that the storage stability of charge in pure PVDF/PTFE nanofibrous material is quite poor (due to the property of the polymers themselves), the nanofibers covered by Parylene C provide even a higher storage stability than that of the plenary Parylene C. It is shown that the charge storage (surface potential) of the precharged PVDF/PTFE/Parylene material is stabilized within one day. With 2-µm-thick Parylene C, the nanofiber film provides both (i) a highly porous and flexible structure and (ii) a relatively more stable surface potential.

As shown in Figure 11b, the initial surface potential of a stack of electret films 5a, 5b, 5c increases linearly with the number of electret layers. Thus, the density of the inducted charge on the electrodes A, B is multiplied by increasing the number of electret layers, and increases the output capability of the device. However, this statement is true only for the case where the total thickness of the electret films 5a, 5b, 5c is negligible compared to the size of the films, otherwise the adding effect of the surface potential minishes with the increase of the total film thickness: as for any e-KEH, energy conversion is obtained thanks to the device capacitance variation under external force.

### 4. Device performance

The device is tested with a varying number of electret layers and with a sweeping load. The output performance of the device is shown in Figure 12. The transient output signal during the test is plotted as the inset of Figure 12a. The average peak value of the output pulses (voltage and power) are calculated accordingly, and the variation of these values are plotted with varied load and varied number of electret layers in Figures 4a-b. As shown in this inset, sharp pulses with large amplitudes and small timespan are generated repetitively with the same frequency of the excitation force.

The increased number of electret layers results in an increased amount of induced charge on the electrodes A, B. At the same time the maximum capacitance is reduced due to a larger gap between electrodes A, B while the minimum capacitance is kept approximately the same. Therefore, there is an optimal number of electret layers. By pressing and releasing the device with finger, we get the average peak voltage of 27 V with the load of 16 MΩ and 3 layers of electret material (optimal condition), corresponding to the optimal instantaneous output power of 45.6 µW.

In an experiment charging a 10 nF capacitor with a full-wave diode rectifier, the voltage reaches 8.5 V with 450 strokes. In this experiment, the energy harvested by each cycle is far less than the case with the optimal resistive load. The reason for this difference comes from the voltage drop of the diodes and the impedance mismatch effect. The power transmitted through the rectifier can be further improved if a better matching is reached, or reduce the voltage drop from the rectifier.

### 5. Conclusion

In this article, we have proposed a non-resonant electrostatic KEH with soft substrate and stacked thin film nanofibrous electret. The charge storage stability of the proposed new type of electret is better than that of the plenary Parylene film electret. The power measurement shows the optimal resistive load of the device to be 16 MΩ, and the optimal number of the stacked electret films 5a, 5b, 5c to be 3. The maximum peak power obtained is 45.6 µW. When the device is working with a full-wave rectifier and a storage capacitor of 10 nF, the voltage reaches 8.5 V with 450 strokes.

### REFERENCES

[1] Chen X, Xu S, Yao N, et al. Nano letters, 2010, 10(6): 2133-2137.
[2] Park K I, Xu S, Liu Y, et al. Nano letters, 2010, 10(12): 4939-4943.
[3] Park K I, Son J H, Hwang G T, et al. Advanced materials, 2014, 26(16): 2514-2520.
[4] Fan F-R, Tian Z Q and Wang Z L, NanoEnergy, 2012, 1(2): 328-334.
[5] McKay T G, Rosset S, Anderson I A and Shea H, Smart Mater. Struct. 24 (2015) 015014
[6] Basset P, Blokhina E and Galayko D, Electrostatic Kinetic Energy Harvesters (2016), Wiley

## Claims

1. Compressible porous fibrous electret film (5a, 5b, 5c), comprising:
- a layer of coated tangled micro/nanofibers (12), which comprises : tangled micro/nanofibers (2) coated with a dielectric conformal coating (3),
said conformal coating (3) conforming the shape of the tangled micro/nanofibers, said conformal coating (3) being adapted to store electrical charges, and being permanently charged with a quantity of electrical charges,
the conformal coating (3) increasing the quantity of electrical charges of the electret film by increasing a storage's surface of the electrical charges, and the coated tangled micro/nanofibers (12) defining pores within the electret film (5a, 5b, 5c).

2. The electret film (5a, 5b, 5c) of claim 1, wherein the micro/nanofibers (2) are polymeric and are flexible.

3. The electret film (5a, 5b, 5c) of claims 1-2, wherein the micro/nanofibers (2) are electrospun micro/nano fibers (11).

4. The electret film (5a, 5b, 5c) of claims 1-3, wherein the conformal coating (3) adapted to store electrical charges is a polymer selected from poly(p-xylylene) polymers, poly(methyl methacrylate) (PMMA), poly(vinylidene fluoride) (PVDF)" fluorinated polymers such as polytetrafluoroethylene or amorphous fluoropolymers of formula

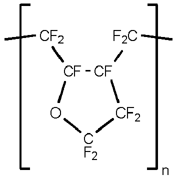

5. The electret film (5a, 5b, 5c) of any of claims 1-4, wherein the electrical charges are located on at least one longitudinal surface of the electret film (5a, 5b, 5c) which behaves as an electret material.

6. The electret film (5a, 5b, 5c) of any of claims 1-4, wherein electric dipoles are created inside the electret film (5a, 5b, 5c) which behaves as a piezo/ferro-electret-like material.

7. An Electrostatic Kinetic Energy Harvester transducer comprising:
1) at least one compressible porous fibrous electret film (5a, 5b, 5c) of any of claims 1 to 6, said electret film (5a, 5b, 5c) being permanently charged with electrical charges of a first sign load,
2) at least two electrodes (A, B) fitted each on an individual support (7), said electrodes A, B having electrical charges of a second sign load opposite to the first sign load electrostatically induced by the charges of the electret film (5a, 5b, 5c),
- at least one electrode being displaceable relative to the other electrode, thereby modifying the capacitance for collecting electrical power,
- the electret film (5a, 5b, 5c) being adapted between the two electrodes (A, B),
- the two electrodes (A, B) being adapted to be displaced between:
a) a released position and a strained position, when a mechanical force is applied to at least one of the electrodes (A, B), the electret film (5a, 5b, 5c) being - in the strained position - compressed, stretched or sheared,
b) the strained position and the released position, when the mechanical force is released,
the position of the electret film (5a, 5b, 5c) relative to the two electrodes (A, B) and the thickness of the electret film (5a, 5b, 5c) being modified during the displacement,
which creates a dissymmetry of the charge distribution between the charges of the two electrodes A, B (A, B) when the two electrodes (A, B) are moving from the strained position to the released position, for collecting electrical power.

8. The electrostatic transducer of claim 7, wherein several stacked electret films (5a, 5b, 5c) forming a mat (5) are arranged between the two electrodes (A, B).

9. The electrostatic transducer of claims 7-8, wherein at least one electret film (5a, 5b, 5c) is flexible, and is mounted between the electrodes (A, B) without spaces between electrodes (A, B) and the electret film(s) (5a, 5b, 5c) in the strained position.

10. The electrostatic transducer of claims 7-9, wherein the mat (5) of stacked electret films (5a, 5b, 5c) is arranged between the two electrodes (A, B) so that there are gaps of air when the mechanical force is released, between electrodes (A, B), and/ or between electret film(s) and electrode, and/or or between two adjacent electret films (5a, 5b, 5c), by mechanical means.

11. The electrostatic transducer of claims 7-10, wherein, when the electrodes (A, B) are in the strained position, a first charged longitudinal surface of the electret film is not into physical contact with an electrode (A or B), a second longitudinal surface opposite to the first charged longitudinal surface being in contact with an electrode (B or A) and being thus charged by triboelectric effect

12. The electrostatic transducer of claims 7-10, wherein, when the electrodes (A, B) are in the strained position, a first charged longitudinal surface of the electret film is into physical contact with an electrode (A or B), and being thus charged by triboelectric effect, a second longitudinal surface opposite to the first charged longitudinal surface being not in contact with an electrode (B or B),

13. The electrostatic transducer of claims 7-12, wherein at least one electrode (B) is covered with an intermediate insulating layer (6) to prevent triboelectric charge generation of same polarity on both electrodes (A, B) at the same time.

14. The electrostatic transducer of claims 7-13, wherein the transducer comprises several electret films (5a, 5b, 5c), optionally stacked and forming a mat (5), said electret films (5a, 5b, 5c) being arranged between the two electrodes (A, B):
- so as to be closer to one electrode (A, B) than to the other electrode (B, A) in the released position, or
- so as to be closer to one electrode (A, B) than to the other electrode in the released position (B, A).

15. The electrostatic transducer of claims 7-14, wherein the transducer comprises several stacked electret films (5a, 5b,5c) forming a mat (5), the number of stacked electret films (5a, 5b,5c) and the distance separating the electrodes (A, B) and electret films (5a, 5b,5c) being selected to optimize the collected electrical power.

16. The electrostatic transducer of claims 7 -15, wherein the transducer comprises more than one pair of electrodes (A, B), and the transducer is an interdigitated comb, with each digit comprising an electrode and a electret film as defined in any of claims 1 to 6.

17. Process for preparing the electret film of any of claims 1-6, comprising depositing a dielectric conformal coating (3) able to be permanently charged with a quantity of electrical charges, in particular through a chemical vapor or atomic layer deposition process, on a layer of micro/nanofibers tangled (11).

18. The process of claim 17, wherein the tangled micro/nanofibers are electrospun micro/nano fibers (11), and the dielectric conformal coating able to be permanently charged with a quantity of electrical charges is a polymer selected from poly(p xylene) polymer, poly(methyl methacrylate) (PMMA), poly(vinylidene fluoride) (PVDF), fluorinated polymers such as polytetrafluoroethylene or amorphous fluoropolymers of formula
